# FASCICULE DE BREVET EUROPEEN

(11) **EP 3 057 389 B1**
(45) Date de publication et mention de la délivrance du brevet: **27.05.2020**
(21) Numéro de dépôt: 16154911.8
(22) Date de dépôt: 09.02.2016
(51) Int. Cl.: F21S 43/14

(54) **DISPOSITIF LUMINEUX POUR UN VÉHICULE AUTOMOBILE INTÉGRANT DES MOYENS DE PROTECTION CONTRE DES DÉCHARGES ÉLECTROSTATIQUES**
BELEUCHTUNGSEINRICHTUNG FÜR FAHRZEUGE MIT SCHUTZ GEGEN ELEKTROSTATISCHE ENTLADUNGEN
LIGHTING DEVICE FOR VEHICLE WITH ELECTROSTATIC DISCHARGE PROTECTION

(30) Priorité: 13.02.2015 FR 1551184
(43) Date de publication de la demande: 17.08.2016
(73) Titulaire: VALEO VISION, 93012 Bobigny Cedex (FR)
(72) Inventeur: ROGER, Christophe, 49070 Saint-Lambert-la-Potherie (FR); PLACAIS, Pierre, 49240 Avrille (FR); JOBARD, Jérome, 49100 Angers (FR)

(56) Documents cités:
- WO-A1-2010/136679
- WO-A1-2014/032914
- DE-B3-102012 213 843
- US-A1- 2006 108 597
- US-A1- 2010 202 151

## Description

L'invention a trait au domaine des dispositifs lumineux pour un véhicule automobile. L'invention concerne en particulier de tels dispositifs faisant intervenir des composants électroniques sensibles à des décharges électrostatiques, tels que par exemple des diodes électroluminescentes.

Dans le domaine des dispositifs lumineux pour véhicules automobiles, l'utilisation de sources lumineuses telles que des diodes électroluminescentes, LEDs, de diodes électroluminescentes organiques, OLED, ou diodes laser est de plus en plus préconisé. Le placement de ces moyens lumineux le long de contours précis permet en effet de créer des signatures optiques intéressantes et individuelles. Cependant, il s'agit de composants électroniques sensibles, notamment à des décharges électrostatiques. Lors du cycle de vie d'un véhicule automobile, de tels composants peuvent être exposés à des décharges électrostatiques à l'intérieur du projecteur dont ils font partie. Par exemple, par frottement de l'air extérieur sur les glaces d'un projecteur, des parties de celles-ci peuvent devenir porteuses de charges statiques. Lorsque les sources lumineuses sont soumises à des décharges provenant de ces pièces, il existe un fort risque de dégradation voir de destruction prématurés des composants électroniques.

Afin de protéger des sources lumineuses, il est connu de prévoir des circuits électroniques de protection dans le dispositif lumineux. Il peut par exemple s'agir d'une capacité électrique montée en parallèle d'une LED, la capacité étant apte à absorber une surcharge éventuelle. Cependant, le coût d'une telle solution augmente proportionnellement avec le nombre des LEDs utilisés. En plus, de tels circuits de protection occupent une partie importante sur les circuits imprimés respectifs, tandis que l'espace au sein du dispositif est restreint.

Le document de brevet US 2002/0151200 A1 décrit un élément circuit de protection d'un dispositif électronique par rapport à des surcharges qui interviennent au sein du circuit électronique comprenant un composant sensible. Un tel système ne peut être utile que si la surcharge ne peut se produire uniquement à un endroit prédéfini du circuit à protéger. Des moyens aptes à rediriger la surcharge vers la masse en amont du composant sensible peuvent alors être intégrés au circuit à protéger. Une telle solution n'est pourtant pas applicable à des cas tels que décrits, dans lesquels une décharge électrostatique peut avoir lieu de manière aléatoire vers un circuit électronique comportant un ou plusieurs composants sensibles. Comme la décharge peut se réaliser sur différentes parties du circuit à protéger, cette solution connue ne permet pas la résolution du problème décrit. Le document US2010/0202151 divulgue un dispositif lumineux de feu arrière comprenant un PCB sur lequel sont disposées des LEDs et des composants électroniques, et un réflecteur susceptible de porter des charges électrostatiques.

Le document WO2010/136679 décrit une façade de commande électronique comprenant un circuit imprimé sur lequel est connecté un microprocesseur, et une pièce métallique, comportant une partie saillante, reliée à la masse. La pièce métallique permet de protéger les composants électroniques du circuit imprimé contre des décharges électrostatiques portées par l'utilisateur de la façade de commande.

L'invention a pour objectif de pallier à au moins un des problèmes posés par l'art antérieur. Plus précisément, l'invention a pour objectif de proposer un dispositif lumineux ayant une protection intégrée des composants électroniques sensibles à une décharge électrostatique.

L'invention a pour objet un dispositif lumineux pour un véhicule automobile. Le dispositif comprend un substrat sur lequel est arrangé au moins un élément d'un circuit électronique. Le circuit électronique comprend au moins un composant électronique sensible à une décharge électrostatique. Le dispositif comprend également une structure qui est distincte du substrat, susceptible de porter des charges électriques. La plus petite distance entre la structure et chacun des éléments du circuit est égale à D1. Le dispositif est remarquable en ce qu'il comprend au moins un élément protecteur contre les décharges électrostatiques ayant au moins une partie de surface électriquement conductrice reliée électriquement à la masse, la plus petite distance entre la partie de surface et la structure, D2, étant inférieure à D1.

L'élément protecteur est donc agencé de sorte à favoriser une décharge électrostatique entre la structure et l'élément protecteur par rapport aux éléments du circuit électronique et permet ainsi de protéger ces éléments du circuit électronique desdites décharges. Avantageusement, l'élément protecteur a pour unique fonction la protection du composant électronique contre lesdites décharges électrostatiques.

De préférence la distance D2 peut être strictement inférieure à 10 mm, tandis que la distance D1 peut être strictement supérieure à 10 mm.

De préférence, les éléments du circuit électronique peuvent comprendre des pistes électriquement conductrices et des composants électroniques connectés aux pistes. L'élément protecteur peut de préférence être un élément en matière plastique, la partie de surface étant revêtue d'une couche électriquement conductrice. Il peut par exemple s'agir d'une couche de cuivre, d'aluminium ou d'un alliage métallique comprenant un métal électriquement conducteur.

De préférence, l'élément protecteur peut présenter une base et s'étend à partir de cette base en s'amincissant pour former une pointe. La partie de surface peut préférentiellement couvrir la pointe de l'élément protecteur.

De manière préférée, l'élément protecteur est en métal électriquement conducteur ou comprend un alliage métallique électriquement conducteur. L'élément protecteur peut comprendre du cuivre ou de l'aluminium.

L'élément protecteur peut de préférence être disposé sur le substrat. L'élément peut être soudé sur le substrat.

Alternativement, l'élément protecteur peut être séparé du substrat.

Le dispositif peut de préférence comprendre des moyens métalliques de dissipation thermique reliés à la masse. L'élément protecteur peut de préférence être formé sur une surface des moyens de dissipation thermique. L'élément protecteur peut par exemple prendre la forme d'un nez ou d'un pic en saillie par rapport à une surface plane des moyens de dissipation thermique. De préférence, l'élément protecteur peut être venu de matière des moyens métalliques de dissipation thermique.

Selon l'invention, le substrat et l'élément protecteur sont disposés d'un même côté de la structure.

Le substrat peut de préférence être le substrat plan d'un circuit imprimé, PCB.

Alternativement, le substrat peut être le substrat d'un dispositif d'interconnexion,, MID, à géométrie complexe. Le substrat du dispositif d'interconnexion peut être moulé ou usiné.

Selon l'invention, le composant électronique peut être une diode électroluminescente, LED, une diode laser, ou une diode électroluminescente organique, OLED. De manière préférée, le circuit électronique peut comprendre une pluralité de LEDs, de OLEDs ou de diodes laser sensibles à des décharges électrostatiques.

Le circuit électrique peut comprendre un groupe comprenant une pluralité de composants électroniques sensibles aux décharges électrostatiques, les composants électroniques de ce groupe étant connectés entre eux. Dans ce cas, le dispositif peut comporter un élément projecteur associé à ce groupe et qui est seul agencé pour protéger tous les composants électroniques de ce groupe.

De manière préférentielle, le circuit électrique peut comprendre une pluralité de groupes comprenant chacun une pluralité de composants électroniques sensibles aux décharges électrostatiques, les composants électroniques de chaque groupe étant connectés entre eux. Dans ce cas, le dispositif peut comporter une pluralité d'éléments protecteurs, chaque élément protecteur étant bijectivement associé à l'un des groupes et étant seul agencé pour protéger tous les composants électroniques de ce groupe.

La structure susceptible de porter des charges électriques peut de préférence être un élément de la glace du dispositif lumineux.

De préférence, le dispositif peut être un feu avant ou un feu arrière d'un véhicule automobile.

Par rapport à des solutions connues, l'effet « paratonnerre » obtenu par les dispositions de la présente invention, permet de réduire les coûts de production d'un dispositif lumineux pour un véhicule automobile, tout en assurant une protection des composants électroniques sensibles à des décharges électrostatiques de manière durable. Les mesures de l'invention définissent un chemin de faible impédance entre la structure susceptible d'être chargée et l'élément de protection, favorisant ainsi la création d'arcs de décharge entre la structure d'une part et l'élément de protection d'autre part. En effet, comme la distance D2 définie selon l'invention est inférieure à la distance D1, le dispositif favorise une décharge électrostatique entre la structure susceptible de porter des charges électriques et l'élément protecteur par rapport aux éléments du circuit électronique. La longévité des composants électroniques et du dispositif sont donc accrues et la complexité des circuits électroniques impliqués est en même temps réduite par rapport à des solutions connues. En effet, en appliquant l'invention proposée, on peut s'affranchir de circuits de protection dédiés impliquant une capacité pour chacune des sources lumineuses d'un tel dispositif. Ceci est particulièrement intéressant lorsqu'un nombre important de telles sources lumineuses, comme par exemple des LEDs, est utilisé dans un dispositif lumineux afin d'obtenir une signature optique particulière. Un ou plusieurs éléments de protection, faciles à réaliser, et positionnés selon les dispositions de l'invention sont capables de protéger une pluralité de telles sources lumineuses contre des décharges électrostatiques aléatoires provenant par exemple de charges accumulées sur une face d'une glace du dispositif.

D'autres caractéristiques et avantages de la présente invention seront mieux compris à l'aide de la description exemplaire et des dessins parmi lesquels :
- la figure 1 illustre de manière schématique une coupe latérale d'un mode de réalisation préférentiel du dispositif selon l'invention ;
- la figure 2 illustre de manière schématique une coupe latérale d'un mode de réalisation préférentiel du dispositif selon l'invention ;
- la figure 3 illustre de manière schématique une coupe latérale d'un mode de réalisation préférentiel du dispositif selon l'invention.

Dans la description qui suit, des numéros de référence similaires seront utilisés pour décrire des concepts similaires à travers des modes de réalisation différents de l'invention. Ainsi, les numéros 100, 200, 300 décrivent un dispositif selon l'invention dans trois modes de réalisation différents.

Sauf indication spécifique du contraire, des caractéristiques techniques décrites en détail pour un mode de réalisation donné peuvent être combinés aux caractéristiques techniques décrites dans le contexte d'autres modes de réalisation décrits à titre exemplaire et non limitatif.

Dans la description suivante, des composants nécessaires au fonctionnement d'un dispositif lumineux pour un véhicule automobile, mais qui n'ont pas d'impact direct par rapport à la présente invention, ne seront pas décrits de manière explicite afin de maintenir la clarté de l'exposé de l'invention. De manière connue, les sources lumineuses d'un dispositif lumineux pour un véhicule automobile sont alimentées par une source de courant interne au véhicule, tel que la batterie du véhicule, et par le biais d'un dispositif de pilotage de l'alimentation comprenant en général au moins un convertisseur. Des convertisseurs adaptés sont en soi connus dans l'état de l'art et sont aptes à convertir une tension continue d'entrée en une tension continue de sortie différente, adaptée à l'alimentation de la ou des sources lumineuses du dispositif. Un dispositif lumineux peut également comprendre de manière connue des moyens optiques destinés à guider les rayons lumineux émis par la ou les sources lumineuses du dispositif. Il peut par exemple s'agir de lentilles optiques et/ou de guides d'ondes. Un dispositif selon l'invention peut en outre réaliser une ou plusieurs fonctions lumineuses du véhicule automobile dans lequel il est installé. Il peut par exemple s'agir de manière non limitative des fonctions feux diurnes, feux de route ou indicateur de direction.

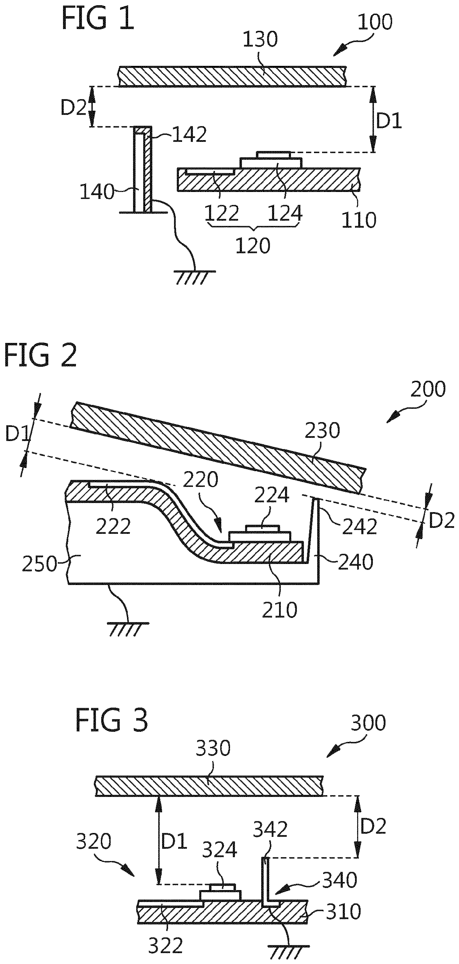

La figure 1 montre une illustration schématique des éléments d'un dispositif 100 selon un mode de réalisation préférentiel de l'invention. Le dispositif comprend un substrat 110 qui supporte un circuit électronique 120. Il peut par exemple s'agir d'une carte de circuit imprimée généralement plane, PCB (« printed circuit board »), ou d'autres substrats en soi connus dans l'art. Le circuit électronique 120 comprend des pistes conductrices 122 et des composants 124 reliés par les pistes conductrices. A titre d'exemple non limitatif, une diode électroluminescente 124, LED, est illustrée. Bien que le substrat illustré ne supporte qu'un seul circuit, il peut également comprendre plusieurs circuits disjoints réalisant des fonctions différentes. La formation de pistes conductrices sur un substrat et la fixation des composants sur le substrat sont en soi connues dans l'art et ne seront pas décrites de manière détaillée dans le cadre de la présente invention.

Le dispositif comprend également une structure 130 qui est susceptible de porter, au moins de manière temporaire, des charges électriques. Il s'agit par exemple d'un élément de la glace du dispositif lumineux, qui peut se charger électriquement lors de la conduite du véhicule par frottement avec l'air extérieur. Dans l'illustration de la figure 1, la structure 130 est montrée comme étant plane. La structure peut néanmoins présenter des géométries différentes et plus complexes. Par exemple, la structure peut avoir une géométrie courbe selon au moins une direction. La plus petite distance entre le substrat qui supporte le circuit 120 et la structure est indiquée par la mesure D1. La distance en question est considérée entre tous les points de la surface de la structure et tous les points du circuit à protéger.

Afin d'éviter qu'une charge présente sur la structure 130 ne vienne se décharger sur un des éléments 122, 124 du circuit électronique 120, ce qui engendrerait un endommagement des composants 124, un élément protecteur ou élément de protection 140 est prévu. L'élément de protection 140 a pour unique fonction la protection du circuit électronique 120 à l'encontre de décharges électrostatiques. L'élément peut être façonné dans une matière plastique et être revêtu au moins sur une partie de sa surface 142 d'une couche électriquement conductrice. Alternativement, l'élément est en matière électriquement conductrice, par exemple en alliage de cuivre, en cuivre ou en aluminium. Dans un mode de réalisation préférentiel, l'élément de protection 140 présente une base à partir de laquelle il s'étende telle que son épaisseur diminue en s'éloignant de la base. La partie de surface 142 couvre idéalement la partie la plus mince, donc la plus éloignée de la base, de l'élément de protection. Cette géométrie exemplaire peut être assimilée à un picot présentant une pointe. La disposition de l'élément de protection 140 est telle que la plus petite distance entre la partie de surface 142 électriquement conductrice et la structure 130, indiquée par la mesure D2, est inférieure à la distance D1. A titre exemplaire, la distance D2 est strictement inférieure à 10 mm, tandis que la distance D1 est strictement supérieure à 10 mm. Evidemment, ce dimensionnement n'est par limitatif par rapport aux dispositions de l'invention. Une charge électrique de la structure cherche le chemin de moindre impédance pour s'évacuer. En utilisant les dispositions de l'invention, ce chemin comprend la partie de surface 142 qui est électriquement connectée au potentiel zéro ou à la masse. Une charge électrique de la structure se décharge donc par un arc électrique entre la structure 130 et la partie de surface 142, d'où elle est évacuée vers la masse. Une telle décharge est donc déviée du circuit 120 sans passer par les composants 124 ou les pistes conductrices 122. La protection du circuit 120 est ainsi assurée sans l'ajout de composants électroniques supplémentaires dans le circuit. La structure comprenant la partie de surface 142 a pour unique fonction la protection du circuit électronique contre des décharges électrostatiques.

L'invention s'applique de manière analogue à des géométries plus complexes, à la fois au niveau de la structure potentiellement porteuse de charges et au niveau du substrat supportant le circuit électronique à protéger. Un exemple est illustré par la coupe de la figure 2, dans lequel le circuit 220 comprenant des pistes conductrices et une LED 224 fait partie d'un substrat 210 de type MID (« molded interconnect device ») ou dispositif d'interconnexion moulé ou usiné. La production de tels dispositifs est en soi connue dans l'art, et elle permet notamment de réaliser des circuits électroniques sur des substrats à géométrie complexe. Le dispositif 200 illustré comprend des moyens de dissipation thermique 250, tels qu'un radiateur métallique. Les moyens de dissipation thermique sont reliés à la masse et sont aptes à dissiper la chaleur produite par les composants du circuit électronique 220. Dans l'exemple montré, l'élément de protection 240 est façonné dans une surface des moyens de dissipation thermique 250. L'élément de protection 240 est dans ce cas venu de matière des moyens métalliques de dissipation thermique 250. Conformément à l'invention, un élément de surface métallique 242 du pic 240 en saillie sur une surface des moyens de dissipation définit le chemin de moindre impédance pour les charges issues de la structure 230.

Le mode de réalisation illustré par le dessin schématique de la figure 3 est semblable à la disposition montrée par la figure 1. Néanmoins, l'élément de protection 340 est formé sur le substrat 310 qui porte le circuit électronique 320 qui est à protéger. L'élément de protection 340 est par exemple réalisé directement dans la matière plastique du substrat et puis métallisé lors du dépôt de couches métalliques qui forment les pistes conductrices 320. Alternativement, l'élément de protection est formé entièrement par dépôt chimique d'un métal conducteur sur le substrat. Encore alternativement, il peut s'agir d'un picot soudé sur le substrat. Dans tous les cas la distance entre la partie de surface métallisée 342, indiquée par D2, et la structure 330, doit être inférieure à la plus petite distance D1 entre la surface et chacun des éléments 322, 324 du circuit 320 qui est à protéger. En plus, la partie de surface métallisée 342 est électriquement reliée à la masse.

Bien que dans les modes de réalisation exemplaires qui viennent d'être décrits, un seul élément protecteur 130, 230, 330 soit illustré, plusieurs éléments similaires peuvent être disposés selon la manière qui vient d'être décrite. Il va de soi que le ou les éléments protecteurs sont aptes à protéger tout circuit électronique disposé sur un ou plusieurs substrats, à condition que la distance D2 telle qu'elle a été définie soit inférieure à la plus petite distance entre la structure susceptible d'être chargée et chacun des éléments de chacun des circuits à protéger.

A condition que les distances D1 et D2 telles que définies entre la structure susceptible d'être chargée et le circuit électronique d'une part, et l'élément de protection d'autre part, sont respectées, l'invention inclut également des modes de réalisation dans lequel le circuit et l'élément de protection sont disposés de part et d'autre de la structure susceptible d'être chargée. Néanmoins, dans le mode de réalisation préféré, dans lequel la structure susceptible d'être chargée est un élément de la glace du dispositif lumineux, qui marque la limite entre l'intérieur et l'extérieur du dispositif, le circuit et l'élément de protection sont disposés d'un même côté de la structure, à savoir à l'intérieur du dispositif lumineux.

En se basant sur la description qui vient d'être donnée et les figures accompagnatrices, l'application de l'invention à des géométries plus complexes sera à la portée de l'homme du métier ayant des connaissances générales dans le domaine.

## Revendications

1. Dispositif lumineux (100, 200, 300) pour un véhicule automobile comprenant
un substrat (110, 210, 310) sur lequel est arrangé au moins un élément (122, 124 ; 222, 224 ; 322, 324) d'un circuit électronique (120, 220, 320) comprenant au moins un composant électronique sensible à une décharge électrostatique, et
une structure qui est distincte du substrat (130, 230, 330) susceptible de porter des charges électriques, la plus petite distance entre la structure et chacun des éléments du circuit (120, 220, 320) étant égale à D1,
**caractérisé en ce que** le dispositif comprend au moins un élément protecteur contre les décharges électrostatiques (140, 240, 340) ayant au moins une partie de surface (142, 242, 342) électriquement conductrice reliée électriquement à la masse, la plus petite distance entre la partie de surface et la structure (130, 230, 330), D2, étant inférieure à D1,
le substrat (110, 210, 310) et l'élément protecteur (140, 240, 340) étant disposés d'un même côté de la structure (130, 230, 330),
le composant électronique étant une diode électroluminescente, LED, une diode laser, ou une diode électroluminescente organique, OLED, et
la structure étant un élément de la glace du dispositif lumineux.

2. Dispositif selon la revendication 1, **caractérisé en ce que** l'élément protecteur (140, 240, 340) est un élément en matière plastique, la partie de surface (142, 242, 342) étant revêtue d'une couche électriquement conductrice.

3. Dispositif selon la revendication 1, **caractérisé en ce que** l'élément protecteur (140, 240, 340) est en métal électriquement conducteur.

4. Dispositif selon une des revendications 1 à 3, **caractérisé en ce que** l'élément protecteur (340) est disposé sur le substrat.

5. Dispositif selon une des revendications 1 à 3, **caractérisé en ce que** l'élément protecteur (140, 240) est séparé du substrat.

6. Dispositif selon une des revendications 1 à 4, **caractérisé en ce que** le dispositif (200) comprend des moyens métalliques de dissipation thermique (250) reliés à la masse, et **en ce que** l'élément protecteur (240) est formé sur une surface des moyens de dissipation thermique (250).

7. Dispositif selon une des revendications 1 à 6, **caractérisée en ce que** le substrat est le substrat plan d'un circuit imprimé, PCB.

8. Dispositif selon une des revendications 1 à 6, **caractérisé en ce que** le substrat est le substrat d'un dispositif d'interconnexion, MID, à géométrie complexe.

9. Dispositif selon une des revendications 1 à 8, **caractérisé en ce que** le dispositif est un feu avant ou un feu arrière d'un véhicule automobile.

## Patentansprüche

1. Eine Lichtvorrichtung (100, 200, 300) für ein Kraftfahrzeug, umfassend
ein Substrat (110, 210, 310), auf dem mindestens ein Element (122, 124; 222, 224; 322, 324) einer elektronischen Schaltung (120, 220, 320) angeordnet ist, die mindestens ein elektronisches Bauelement umfasst, das gegenüber einer elektrostatischen Entladung empfindlich ist, und
eine Struktur, die sich vom Substrat (130, 230, 330) unterscheidet und elektrische Ladungen tragen kann, wobei der kleinste Abstand zwischen der Struktur und jedem der Schaltungselemente (120, 220, 320) gleich D1 ist,
**dadurch gekennzeichnet, dass** die Vorrichtung mindestens ein Schutzelement (140, 240, 340) gegen elektrostatische Entladungen umfasst, das mindestens einen elektrisch leitenden Oberflächenabschnitt (142, 242, 342) aufweist, der elektrisch mit der Erde verbunden ist, wobei der kleinste Abstand zwischen dem Oberflächenabschnitt und der Struktur (130, 230, 330), D2, kleiner als D1 ist,
wobei das Substrat (110, 210, 310) und das Schutzelement (140, 240, 340) auf derselben Seite der Struktur (130, 230, 330) angeordnet sind,
wobei das elektronische Bauelement eine Leuchtdiode, LED, Laserdiode oder organische Leuchtdiode, OLED, ist und
wobei die Struktur ein Element des Glases der Beleuchtungseinrichtung ist.

2. Vorrichtung nach Anspruch 1, **dadurch gekennzeichnet, dass** das Schutzelement (140, 240, 340) ein Kunststoffelement ist, wobei der Oberflächenabschnitt (142, 242, 342) mit einer elektrisch leitenden Schicht überzogen ist.

3. Vorrichtung nach Anspruch 1, **dadurch gekennzeichnet, dass** das Schutzelement (140, 240, 340) aus elektrisch leitendem Metall besteht.

4. Vorrichtung nach einem der Ansprüche 1 bis 3, **dadurch gekennzeichnet, dass** das Schutzelement (340) auf dem Substrat angeordnet ist.

5. Vorrichtung nach einem der Ansprüche 1 bis 3, **dadurch gekennzeichnet, dass** das Schutzelement (140, 240) vom Substrat getrennt ist.

6. Vorrichtung nach einem der Ansprüche 1 bis 4, **dadurch gekennzeichnet, dass** die Vorrichtung (200) metallische Wärmeableitungsmittel (250) umfasst, die mit der Erde verbunden sind, und dass das Schutzelement (240) auf einer Oberfläche der Wärmeableitungsmittel (250) ausgebildet ist.

7. Vorrichtung nach einem der Ansprüche 1 bis 6, **dadurch gekennzeichnet, dass** das Substrat das planare Substrat einer gedruckten Leiterplatte, PCB, ist.

8. Vorrichtung nach einem der Ansprüche 1 bis 6, **dadurch gekennzeichnet, dass** das Substrat das Substrat einer Verbindungsvorrichtung, MID, mit einer komplexen Geometrie ist.

9. Vorrichtung nach einem der Ansprüche 1 bis 8, **dadurch gekennzeichnet, dass** die Vorrichtung eine Front- oder Heckleuchte eines Kraftfahrzeugs ist.

## Claims

1. A lighting device (100, 200, 300) for a motor vehicle comprising
a substrate (110, 210, 310) on which is arranged at least one element (122, 124; 222, 224; 322, 324) of an electronic circuit (120, 220, 320) comprising at least one electronic component sensitive to an electrostatic discharge, and
a structure that is distinct from the substrate (130, 230, 330) capable of carrying electrical charges, the smallest distance between the structure and each of the circuit elements (120, 220, 320) being equal to D1,
**characterised in that** the device comprises at least one electrostatic discharge protective element (140, 240, 340) having at least one electrically conductive surface portion (142, 242, 342) electrically connected to ground, the smallest distance between the surface portion and the structure (130, 230, 330), D2, being less than D1,
the substrate (110, 210, 310) and the protective element (140, 240, 340) being arranged on the same side of the structure (130, 230, 330),
the electronic component being a light-emitting diode, LED, laser diode, or organic light-emitting diode, OLED, and
the structure being an element of the glass of the lighting device.

2. Device according to claim 1, **characterized in that** the protective element (140, 240, 340) is a plastic element, the surface portion (142, 242, 342) being coated with an electrically conductive layer.

3. Device according to claim 1, **characterized in that** the protective element (140, 240, 340) is made of electrically conductive metal.

4. Device according to one of claims 1 to 3, **characterized in that** the protective element (340) is arranged on the substrate.

5. Device according to one of claims 1 to 3, **characterized in that** the protective element (140, 240) is separated from the substrate.

6. Device according to one of claims 1 to 4, **characterized in that** the device (200) comprises metallic heat dissipation means (250) connected to ground, and **in that** the protective element (240) is formed on a surface of the heat dissipation means (250).

7. A device according to one of claims 1 to 6, **characterized in that** the substrate is the planar substrate of a printed circuit board, PCB.

8. A device according to one of claims 1 to 6, **characterized in that** the substrate is the substrate of an interconnection device, MID, with a complex geometry.

9. A device according to one of claims 1 to 8, **characterized in that** the device is a front lamp or a rear lamp of a motor vehicle.
